# EUROPEAN PATENT APPLICATION

(11) **EP 4 657 442 A1**
(43) Date of publication of application: **03.12.2025**
(21) Application number: 24179327.2
(22) Date of filing: 31.05.2024
(51) Int. Cl.: G11C 29/00, G11C 29/08, G11C 29/24, G11C 29/44, G11C 29/52, G11C 29/04, B60L 3/00

(54) **METHOD AND COMPUTER SYSTEM FOR DATA RECOVERY IN A BATTERY MANAGEMENT SYSTEM**

(71) Applicant: VOLVO TRUCK CORPORATION, 405 08 Göteborg (SE)
(72) Inventor: RAY, Dripta, 412 76 GÖTEBORG (SE); SONG, Yeegahng, 417 18 GÖTEBORG (SE)
(74) Representative: Ström & Gulliksson AB

(57) **Abstract**

A computer system is provided, comprising processing circuitry configured to perform a flaw check of a first memory section (52) of a first memory node (50) of a data storage module (214, 224); detect a faulty memory block (54) in the first memory section (52) of the first memory node (50); and extend the first memory section (52) of the first memory node (50) with a new memory block (56) corresponding to the faulty memory block (54) of the first memory section (52). The processing circuitry is further configured to: recover the new memory block (56) of the extended first memory section (52) of the first memory node (50) from a backup memory section (58, 58').

## Description

### TECHNICAL FIELD

The disclosure relates generally to battery management systems. In particular aspects, the disclosure relates to methods and systems for battery management. The disclosure can be applied to heavy-duty vehicles, such as trucks, buses, and construction equipment, among other vehicle types. Although the disclosure may be described with respect to a particular vehicle, the disclosure is not restricted to any particular vehicle.

### BACKGROUND

Battery management systems are used in various applications comprising battery-powered devices. The battery management system is typically designed to control an assembly of battery cells, such as a battery pack assembly, in order to ensure proper delivery of electrical power to a dedicated load.

The battery management system may be responsible for a plurality of tasks, including but not limited to monitoring of the operation of the battery cells, providing battery cell protection, determining actual operating state of the battery cells, optimizing battery cell performance, as well as providing operation status data to associated devices.

Data storage is crucial for any battery management system, not only for collecting and storing the substantial amount of data relating to historical performance and real-time monitoring of metrics. Data storage is also required for specific software used for providing the dedicated algorithms for e.g. parameter control and measurements, state-of-charge and state-of-health assessment, fault detection, and passive cell balancing.

When the data storage is subject to an irrecoverable fault, the common practice is to shut down the entire battery management system. This is particularly important in electric vehicle applications, where data storage faults may cause significant safety issues.

In view of above, there is a need for improved methods and computer systems for battery management, especially with regards to recovery of data.

### SUMMARY

According to a first aspect of the disclosure, a computer system is provided. The computer system comprises processing circuitry configured to perform a flaw check of a first memory section of a first memory node of a data storage module; detect a faulty memory block in the first memory section of the first memory node; and extend the first memory section of the first memory node with a new memory block corresponding to the faulty memory block of the first memory section; wherein the processing circuitry is further configured to: recover the new memory block of the extended first memory section of the first memory node from a backup memory section. The first aspect may seek to improve safety and robustness by avoiding data loss. A technical benefit may include enabling automatic memory recovery also during operation of an associated energy storage system, or battery management systems of a vehicle. Although the examples of this disclosure are particularly mentioned with respect to vehicles, it should be mentioned that the aspects and examples disclosed herein are also applicable for any energy storage system, also including marine, stationary, and industrial energy storage systems.

Optionally in some example, including in at least one preferred example, the processing circuitry is further configured to: perform a flaw check of a backup memory section of the first memory node; detect at least one faulty memory block in the backup memory section of the first memory node; and recover the new memory block of the extended first memory section of the first memory node from one backup memory section of another memory node. A technical benefit may include improved robustness and redundancy.

Optionally in some example, including in at least one preferred example, the processing circuitry is further configured to: recover the backup memory section of the first memory node from one backup memory section of another memory node; and recover the new memory block of the extended first memory section of the first memory node from the backup memory section of the first memory node. A technical benefit may include improved data quality and robustness.

Optionally in some examples, including in at least one preferred example, the processing circuitry is further configured to: extending the first memory section of the first memory node by extending a second non-used memory section of the first memory node with a new memory block corresponding to the faulty memory block of the first memory section; and assigning the new memory block of the second memory section to the first memory section. A technical benefit may include efficient data recovery.

Optionally in some examples, including in at least one preferred example, the processing circuitry is further configured to: update the backup memory section of the first memory node from the extended first memory section of the first memory node. A technical benefit may include improved robustness by ensuring an updated backup memory section.

Optionally in some examples, including in at least one preferred example, the processing circuitry is further configured to initiate an operational cycle of a battery management system; and perform the flaw check of a faulty memory block in the first memory section of the first memory node when the operational cycle of the battery management system is initiated. A technical benefit may be include checking the data memory upon startup, thereby reducing the risk for memory related errors during operation of the associated vehicle.

Optionally in some examples, including in at least one preferred example, the processing circuitry is further configured to initiate a data update, and perform the flaw check of a faulty memory block in the first memory section of the first memory node based on the initiated data update. A technical benefit may include a quality check before data is updated, thereby improving reliability of the data memory and the data update process.

According to a second aspect of the disclosure, an energy storage system is provided. The energy storage system comprises at least one battery pack, at least one data storage module, and the computer system of the first aspect. A technical benefit may include applying a robust and reliable data recovery for critical components especially of a vehicle, thereby reducing downtime and standstill of the vehicle.

According to a third aspect of the disclosure, a vehicle is provided. The vehicle comprises the energy storage system of the second aspect. The second aspect may seek to improve safety and robustness by avoiding data loss in vehicles. A technical benefit may include enabling automatic memory recovery also during operation of an associated energy storage system of the vehicle.

Optionally in some examples, including in at least one preferred example, the vehicle further comprises a battery management system configured to control the operation of the energy storage system, wherein the battery management system comprises at least one data storage module. A technical benefit may include improved operation and data recovery of the battery management system.

Optionally in some examples, including in at least one preferred example, the data storage module comprises a plurality of memory nodes. A technical benefit may include the possibility for distributed backup and data recovery of the data storage module.

Optionally in some examples, including in at least one preferred example, at least one memory node comprises a backup section. A technical benefit may include improved reliability and data robustness of the memory node.

Optionally in some examples, including in at least one preferred example, the at least one memory node comprises a backup section for each memory node of the data storage module. A technical benefit may include the possibility for distributed backup and data recovery of multiple data nodes of the data storage module.

Optionally in some examples, including in at least one preferred example, each memory node comprises a backup section for each memory node of the data storage module. A technical benefit may include an even greater possibility for distributed backup and data recovery of multiple data nodes of the data storage module.

According to a fourth aspect of the disclosure, a computer-implemented method is provided. The computer-implemented method comprises performing, by processing circuitry of a computer system, a flaw check of a first memory section of a first memory node of a data storage module; detecting, by the processing circuitry, a faulty memory block in the first memory section of the first memory node of the data storage module; and extending, by the processing circuitry, the first memory section of the first memory node with a new memory block corresponding to the faulty memory block of the first memory section; wherein the method further comprises: recovering, by the processing circuitry, the new memory block of the extended first memory section of the first memory node from a backup memory section.

Optionally in some examples, including in at least one preferred example, the method further comprises: performing, by the processing circuitry, a flaw check of a backup memory section of the first memory node; detecting, by the processing circuitry, at least one faulty memory block in the backup memory section of the first memory node; and recovering, by the processing circuitry, the new memory block of the extended first memory section of the first memory node from one backup memory section of another memory node.

Optionally in some examples, including in at least one preferred example, the method further comprises: recovering, by the processing circuitry, the backup memory section of the first memory node from one backup memory section of another memory node ; and recovering, by the processing circuitry, the new memory block of the extended first memory section of the first memory node from the backup memory section of the first memory node.

Optionally in some examples, including in at least one preferred example, the method further comprises extending, by the processing circuitry, the first memory section of the first memory node by extending a second non-used memory section of the first memory node with a new memory block corresponding to the faulty memory block of the first memory section; and assigning, by the processing circuitry, the new memory block of the second memory section to the first memory section. A technical benefit may include efficient data recovery.

Optionally in some examples, including in at least one preferred example, the method further comprises updating, by the processing circuitry, the backup memory section of the first memory node from the extended first memory section of the first memory node. A technical benefit may include improved robustness by ensuring an updated backup memory section.

Optionally in some examples, including in at least one preferred example, the method further comprises initiating, by the processing circuitry, an operational cycle of a battery management system; and performing, by the processing circuitry, the flaw check of the first memory section of the first memory node when the operational cycle of the battery management system is initiated. A technical benefit may be include checking the data memory upon startup, thereby reducing the risk for memory related errors during operation of the associated vehicle.

Optionally in some examples, including in at least one preferred example, the method further comprises performing, by the processing circuitry, the flaw check of the first memory section of the first memory node when the operational cycle of the battery management system is running. A technical benefit may be include checking the data memory during operation, thereby further reducing the risk for memory related errors during operation of the associated vehicle.

Optionally in some examples, including in at least one preferred example, the method further comprises initiating a data update, and performing, by the processing circuitry, the flaw check of a faulty memory block in the first memory section of the first memory node based on the initiated data update. A technical benefit may include a quality check before data is updated, thereby improving reliability of the data memory and the data update process.

According to a fifth aspect of the disclosure, a computer program product is provided. The computer program product comprises program code for performing, when executed by the processing circuitry, the method of the fourth aspect.

According to a sixth aspect of the disclosure, a non-transitory computer-readable storage medium is provided. The non-transitory computer-readable storage medium comprises instructions, which when executed by the processing circuitry, cause the processing circuitry to perform the method of the fourth aspect.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

**FIG. 1** is an exemplary side view of a vehicle according to an example.
**FIG. 2** is an exemplary diagram of a battery management system according to an example.
**FIG. 3** is an exemplary diagram of a data recovery system according to an example.
**FIG. 4A** is a flow chart of an exemplary data recovery method according to an example.
**FIG. 4B** is a diagram of the exemplary data recovery method shown in **FIG. 4A****.**
**FIG. 5A** is a flow chart of an exemplary data recovery method according to an example.
**FIG. 5B** is a diagram of the exemplary data recovery method shown in **FIG. 5A****.**
**FIG. 6A** is a flow chart of an exemplary data recovery method according to an example.
**FIG. 6B** is a diagram of the exemplary data recovery method shown in **FIG. 6A****.**
**FIG. 7** is a schematic diagram of an exemplary computer system for implementing examples disclosed herein, according to an example.

### DETAILED DESCRIPTION

The detailed description set forth below provides information and examples of the disclosed technology with sufficient detail to enable those skilled in the art to practice the disclosure.

The examples presented herein provide a solution to the problem of irrecoverable errors in a memory of a battery management system. Instead of shutting down the battery management system and replace the erroneous data memory, the present disclosure supports automatic data backup in a dynamic and distributed manner. By detecting and recovering bad data memory blocks during operation of the vehicle, any battery management system using embedded data storage architecture does not need to be stopped and subject to standstill service or maintenance due to any partial memory corruption.

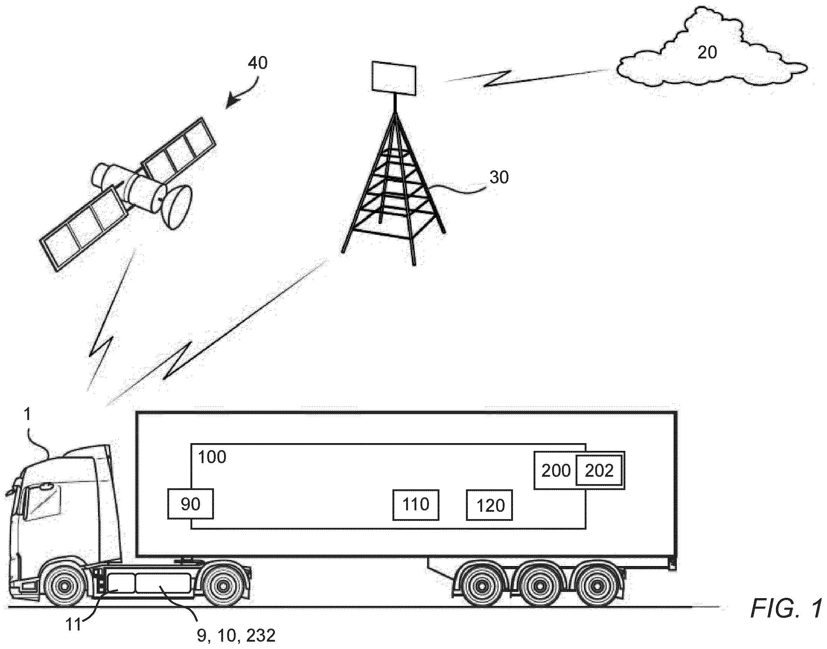

**FIG. 1** is an exemplary view of a vehicle **1** according to one example. The vehicle **1** comprises at least one energy storage system **9.** The at least one energy storage system **9** comprises one or more battery packs **232** configured to provide electrical energy to a suitable component of the vehicle **1,** for example to one or more electrical motors **11.** The one or more electrical motors **11** may e.g. be electrical traction motors providing propulsive force to the vehicle **1.** Typically, the energy storage system **9** is controlled by a battery management system unit **10,** acting as a master controller for the entire energy storage system **9.** Each battery pack **232** is preferably controlled by a dedicated battery management system 12 such that the battery management system unit **10** provide control signals for each battery management system **12.** The vehicle **1** is programmed to control data recovery, as will be described further in the following.

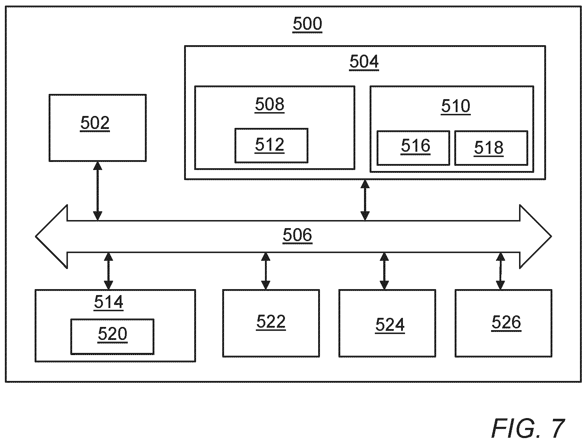

The vehicle **1** comprises, at least to some extent, processing circuitry **110** forming part of a computer system **100** (see **FIG. 7****).** The processing circuitry **110** is configured to implement a battery management control system **200** which is configured to be operatively connected to the at least one battery management system unit **10** and/or one or more battery management systems **12.**

The vehicle **1** may further comprise communications circuitry **90** configured to receive and/or send communications. The communications circuitry **90** may be configured to enable the vehicle **1** to communicate with one or more external devices or systems such as a cloud server **20.** The communication with the external devices or systems may be directly or via a communications interface such as a cellular communications interface **30,** such as a radio base station. The cloud server **20** may be any suitable cloud server exemplified by, but not limited to, Amazon Web Services (AWS), Microsoft Azure, Google Cloud Platform (GCP), IBM Cloud, Oracle Cloud Infrastructure (OCI), DigitalOcean, Vultr, Linode, Alibaba Cloud, Rackspace etc. The communications interface may be a wireless communications interface exemplified by, but not limited to, Wi-Fi, Bluetooth, Zigbee, Z-Wave, LoRa, Sigfox, 2G (GSM, CDMA), 3G (UMTS, CDMA2000), 4G (LTE), 5G (NR) etc. The communication circuitry **90** may, additionally or alternatively, be configured to enable the vehicle **1** to be operatively connected to a Global Navigation Satellite System (GNSS) **40** exemplified by, but not limited to, global positioning system (GPS), Globalnaya Navigatsionnaya Sputnikovaya Sistema (GLONASS), Galileo, BeiDou Navigation Satellite System, Navigation with Indian Constellation (NavIC) etc. The vehicle **1** may for example be configured to utilize data obtain from the GNSS **40** to determine a geographical location of the vehicle **1.**

The vehicle **1** in **FIG. 1** comprises the computer system **100** and the battery management control system **200.** The computer system **100** may be operatively connected to the battery management control system **200** and optionally to the communications circuitry **90** of the vehicle **1.** The computer system **100** comprises processing circuitry **110.** The computer system **100** may comprise a storage device **120,** advantageously a non-volatile storage device such as a hard disk drives (HDDs), solid-state drives (SSDs) etc. In some examples, the storage device **120** is operatively connected to the computer system **100.** The battery management control system **200** may comprise battery management control system processing circuitry **202;** the battery management control system processing circuitry **202** may be part of the processing circuitry **110** of the computer system **100.**

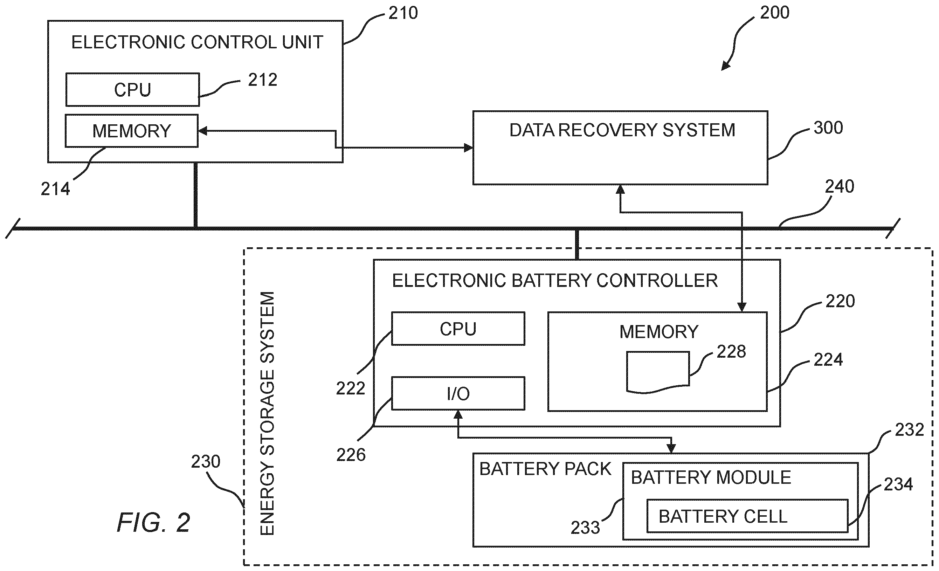

**FIG. 2** is a schematic diagram of a battery management system **200.** As illustrated in **FIG. 2****,** the battery management control system **200** includes an electronic control unit **210,** an electrical energy storage system **230,** and a communication bus **240.** The electrical energy storage system **230** comprises an electronic battery controller **220** and may preferably be implemented as the battery management system **12** shown in **FIG. 1****.** In such example, the battery management system **10** is configured to act as a control system for an associated battery pack **232.** Optionally, the electronic battery controller **220** may be implemented as the battery management system unit **12,** thus acting as a master controller for multiple battery management systems **10,** whereby each battery management system **10** is configured to control a dedicated battery pack **232.** While only one battery pack **232** is shown in **FIG. 2****,** it should be noted that in several realizable examples, multiple battery packs **232** may be present.

The electronic control unit **210** includes a central processing unit **212** (CPU), and at least one computer memory **214.**

The ECU **210** is operatively coupled to the bus **240.** For example, the ECU **210** includes a data communication interface connected to the bus **240** through a wired link.

The bus **240** may be a wired vehicle bus allowing exchange of data across the vehicle 1. In some embodiments, the bus **240** is a Local Interconnect Network bus (LIN). In alternative embodiments, the bus **240** may be defined according to a different topology and/or to a different standard, such as the Controller Area Network bus (CAN). The bus **240** may alternatively be a wireless vehicular network.

The central processing unit **212** is able to execute executable instructions stored in the memory **214.** For example, the central processing unit **212** is a programmable microcontroller or a microprocessor.

The memory **214** may be a non-volatile computer memory (e.g. a non-transitory computer-readable medium), for example including one or several data storage modules of the electrically-erasable programmable read-only memory (EEPROM) technology or the flash technology, or of any appropriate data storage technology.

The energy storage system **230** is configured to provide electrical power to at least one device of the vehicle **1** (such as the electrical motor **11** shown in **FIG. 1****),** for example by means of a power delivery bus, not illustrated. The energy storage system **230** may also power the ECU **210** and the battery controller **220.**

The energy storage system **230** comprises the electronic battery controller **220** and one or more battery packs **232.** Each battery pack **232** typically comprises one or more battery modules **233,** which in turn comprises a plurality of battery cells **234.** Each battery pack **232** may include power conversion means and/or commendable power regulation means, not illustrated, in order to regulate the delivered electrical power.

The battery controller **220** is configured to evaluate and monitor properties of the energy storage system **230,** such as the state of charge and/or the state of health of the energy storage system **230** or, more precisely, of one or several of the battery packs **232.** The battery controller **220** is also programmed to forward this information to the ECU **210** through the bus **240.** For example, the ECU **210** is connected to the battery controller **220** through the bus **240** and is adapted to control the behavior of the electric motor **10** and/or the behavior of the vehicle **1** depending on the value(s) of the battery-related properties monitored and forwarded by the battery controller **220.**

In some examples, the battery controller **220** includes a CPU **222 ,** a computer memory **224** and a device **226** for acquiring at least one electrical value of the energy storage system **230.** The CPU **222** is able to execute instructions stored in the memory **224.** For example, the CPU **222** is a programmable micro controller. The memory **224** may be a non-volatile computer memory (e.g. a non-transitory computer-readable medium), for example including one or several memory modules of EEPROM technology, or Flash technology, or, alternatively, of any appropriate data storage technology.

The memory **224** stores, among other things, a battery profile **228.** For example, the memory **224** comprises a slot, that is to say a predefined memory space that is meant to host a battery profile **228.** For example, the battery profile **228** takes the form of a digital data structure recorded into memory **224.** Preferably, the battery controller **220** is setup so that no more than one battery profile **228** can be stored inside the memory **224.** In other words, while the memory **224** may store additional data and/or instructions, it is not meant to store more than one battery profile **228.**

The battery profile **228** may for example comprise a calibration data set representative of the electrical properties and response of the energy storage system **230.** For example, the battery profile **228** gives a correspondence between at least one measurable electrical value of the battery pack **232** (such as output electrical voltage, output electrical current, electrical resistance, etc.) and at least one indicator representative of the physical state of the battery (such as the State of Charge, State of Health, etc.)

The battery management system **200** further comprises a data recovery system **300** operatively connected to at least one of the memory **214** of the ECU **210** and the memory **224** of the battery controller **220.** The data recovery system **300** may or may not form part of the energy storage system **230.**

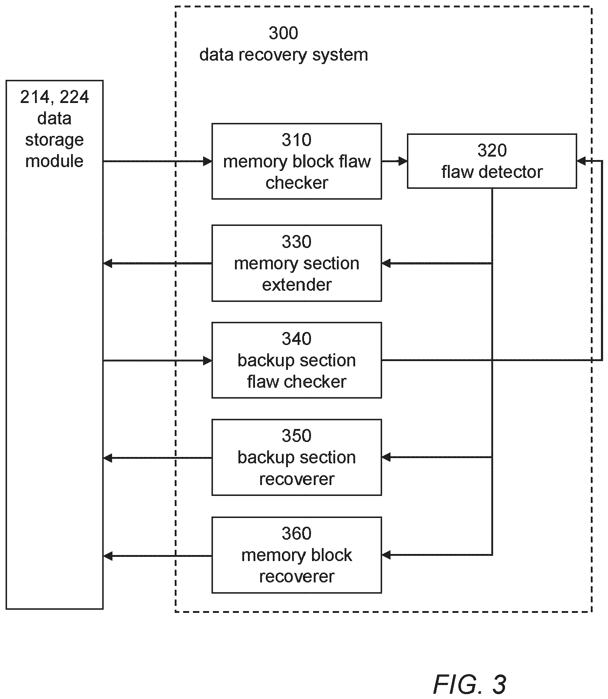

The data recovery system **300** is further shown in **FIG. 3****.** The data recovery system **300** operates with a data storage module, for example in the form of one or more of the memories **214, 224** described with reference to **FIG. 2****.**

The data recovery system **300** comprises a memory block flaw checker **310.** The memory block flaw checker **310** is configured to perform a flaw check of a first memory section of a first memory node of the data storage module **214, 224.** The purpose of the memory block flaw checker **310** is to check for any faulty memory blocks in the first memory section.

The data recovery system **300** further comprises a flaw detector **320.** The flaw detector **320** is configured to detect a faulty memory block in the first memory section of the first memory node.

The data recovery system **300** further comprises a memory section extender **330** configured to extend the first memory section of the first memory node with a new memory block corresponding to the faulty memory block of the first memory section.

The data recovery system **300** comprises a backup section flaw checker **340.** The backup section flaw checker **340** is configured to perform a flaw check of a backup memory section of the first memory node for any faulty memory blocks.

The flaw detector **320** is further configured to detect at least one faulty memory block in the backup memory section of the first memory node, and a backup section recoverer 350 is configured to recover the backup memory section of the first memory node from one backup memory section of another memory node.

The data recovery system **300** further comprises a memory block recoverer **360** configured to recover the new memory block of the extended first memory section of the first memory node from the backup memory section of the first memory node.

Alternately, if the backup section flaw checker **340** and the flaw detector **320** fails to detect a faulty memory block in the backup memory section of the first memory node, the memory block recoverer **360** is configured to recover the new memory block of the extended first memory section of the first memory node from the backup memory section of the first memory node.

Notably, the memory block recoverer **360** is configured to recover the new memory block of the extended first memory section of the first memory node from one backup memory section of another memory node. This may be done directly, i.e. the backup memory section of another memory node is directly accessed, or indirectly, i.e. the backup memory section of another memory node is accessed to recover the backup memory section of the first memory node (which in turn is used to recover the new memory block of the extended first memory section of the first memory node).

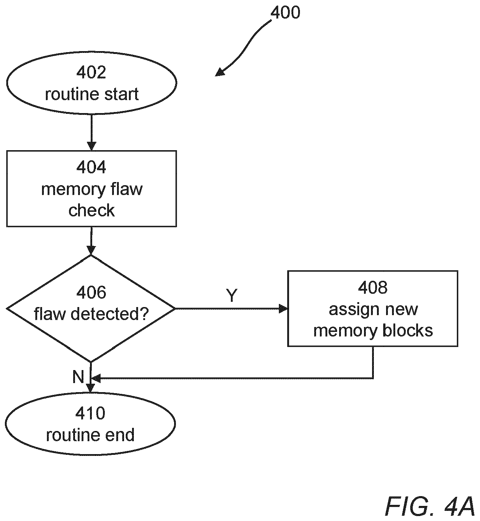

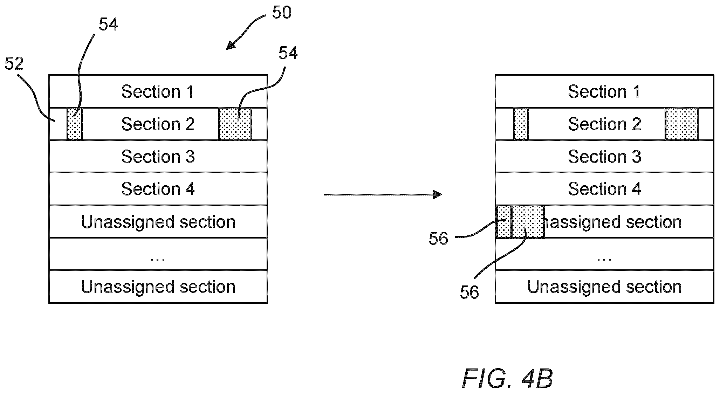

In **FIGS. 4A-B** an example of a data recovery method **400** is schematically illustrated, and in the following simultaneous reference to these drawings is provided. The method **400** is initiated by a routine start **402.** The routine start **402** may for example be initiated by start-up of the battery management system **200,** before or after a data update, or during operation of an associated vehicle **1.** At **404** the method **400** performs a memory flaw check. When a flaw is detected in **406,** as further indicated in **FIG. 4B** by the highlighted areas **54** in Section 2, indicating flawed memory blocks **54,** new memory blocks **56** are assigned by any suitable redirection technique. Notably, if a redirection table is used this should preferably be updated during the memory's lifetime. The method **400** ends at **410** when the new memory blocks **56** are appropriately assigned.

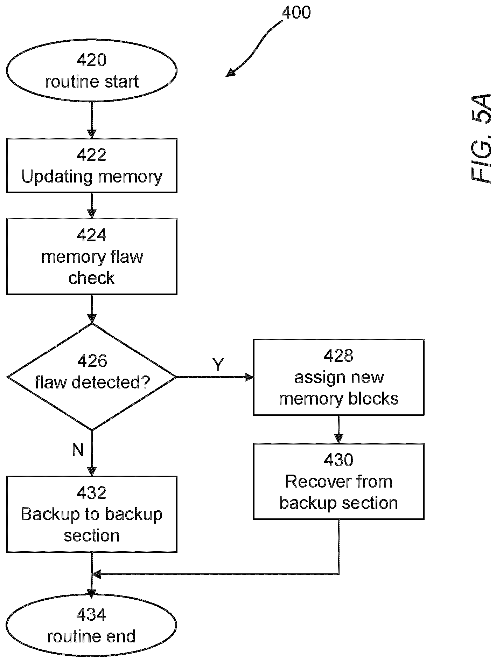

In **FIGS. 5A-B** another example of a data recovery method **400** is schematically illustrated, and in the following simultaneous reference to these drawings is provided.

The flaw check routine contains a step of backup of the data and an optional step of recovery to be undertaken automatically. In the memory, there can be a pre-allocated section **58** as a primary backup for data recovery in the same system for example locally in a module memory. When a flaw is detected in a memory location, while the embedded system is in use or the energy storage system is under load, it can continue to be used by copying the data lost in the flawed area **54** of the memory node **50** from the backup section **58** and assigning it to the newly allocated memory location **53** for the first memory section **52** where the bad block **54** was detected.

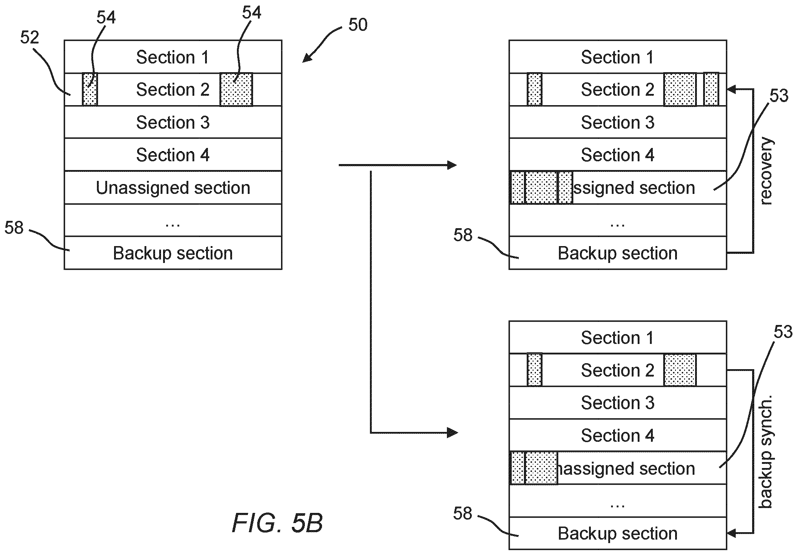

The method **400** is initiated by a routine start **420.** At **422** the method **400** may perform a data update. During or after the data update **422,** the method **400** performs a memory flaw check **424.** When a flaw is detected in **426,** as further indicated in **FIG. 5B** by the highlighted area **54** in Section 2 of the upper right part in the drawing, indicating an additional flawed memory block **54,** a new memory block **56** is assigned at **428** by any suitable redirection technique. Subsequently, the data of the first memory section **52** (i.e. Section 2 of **FIG. 5B****)** may be recovered **430** from the backup memory section **58.**

If no new bad memory block is detected in **426,** the method **400** may proceed in **432** by synchronizing the backup section **58** to the first memory section **52,** i.e. Section 2 in **FIG. 5B****.**

The method **400** ends at **434** when the new memory blocks are appropriately assigned and/or backup and synchronization is completed.

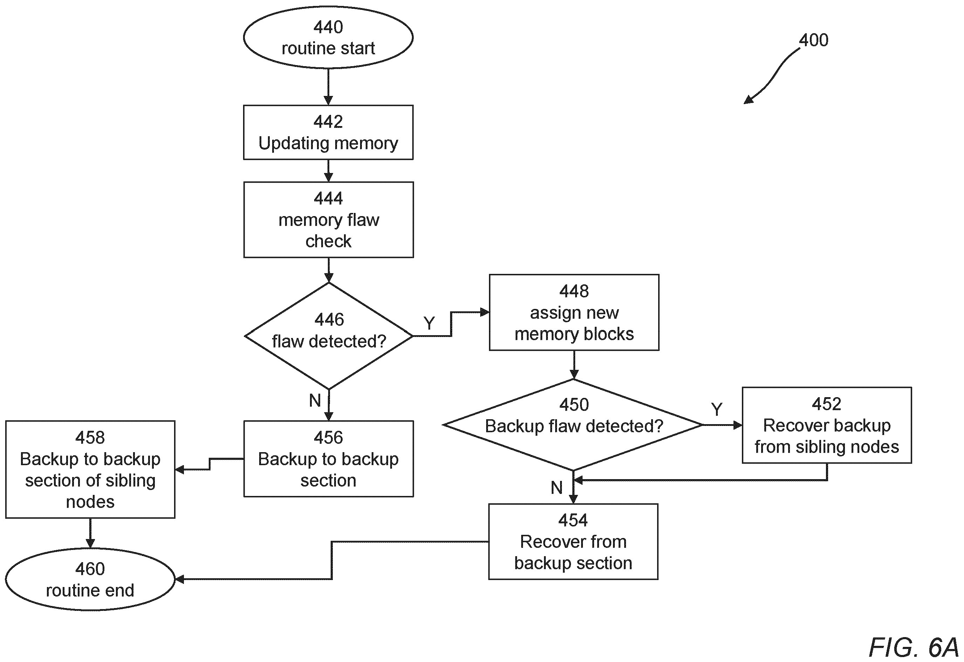

In **FIGS. 6A-B** another example of a data recovery method **400** is schematically illustrated, and in the following simultaneous reference to these drawings is provided. The described method **400** is an extension of the method **400** described with reference to **FIGS. 5A-B****,** by storing the copy of the backup section **58** to multiple locations (i.e. multiple data storage modules **50')** to increase the robustness even further to restore when the original system has corrupted completely (i.e. when both the first memory section and backup section are lost).

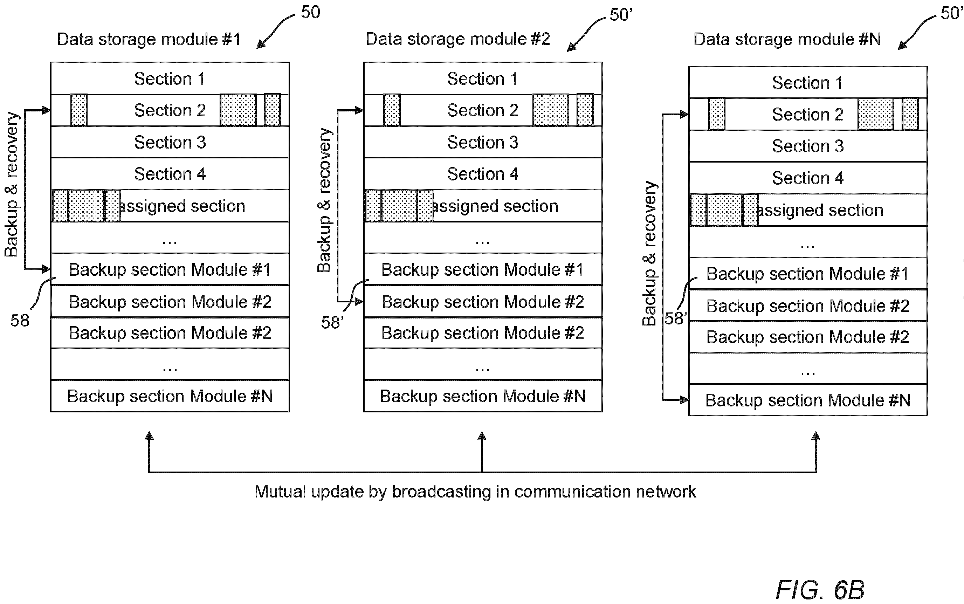

The method **400** is initiated by a routine start **440.** At **442** the method **400** may perform a data update. During or after the data update **442,** the method **400** performs a memory flaw check **444.** When a flaw **54** is detected in **446,** as further indicated in **FIG. 6B****,** a new memory block **56** is assigned at **448** by any suitable redirection technique. Subsequently, a check **450** is made if the backup section is corrupt. If not, the data of the first memory section **52** (i.e. Section 2 of **FIG. 6B****)** may be recovered **454** from the backup memory section **58.**

However, if the backup section **58** has a flaw, the method **400** proceeds by recovering **452** the backup section **58** from any sibling memory node **58'** connected in the same network. This is indicated by the bottom distribution link in **FIG. 6B****.**

If no new bad memory block is detected in **446,** the method **400** may proceed in **456** by synchronizing the backup section **58** to the first memory section **52,** i.e. Section 2 in **FIG. 5B****.** The method **400** further proceeds in synchronizing **458** the backup section **58, 58'** of each connected sibling node **50, 50** to the first memory section **52.**

The method **400** ends at **460** when the new memory blocks are appropriately assigned and/or backup and synchronization is completed.

**FIG. 7** is a schematic diagram of a computer system **500** for implementing examples disclosed herein. The computer system **500** is adapted to execute instructions from a computer-readable medium to perform these and/or any of the functions or processing described herein. The computer system **500** may be connected (e.g., networked) to other machines in a LAN, an intranet, an extranet, or the Internet. While only a single device is illustrated, the computer system **500** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **500** may comprise at least one computing device or electronic device capable of including firmware, hardware, and/or executing software instructions to implement the functionality described herein. The computer system **500** may include processing circuitry **502** (e.g., processing circuitry including one or more processor devices or control units), a memory **504,** and a system bus **506.** The computer system **500** may include at least one computing device having the processing circuitry **502.** The system bus **506** provides an interface for system components including, but not limited to, the memory **504** and the processing circuitry **502.** The processing circuitry **502** may include any number of hardware components for conducting data or signal processing or for executing computer code stored in memory **504.** The processing circuitry **502** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **502** may further include computer executable code that controls operation of the programmable device.

The system bus **506** may be any of several types of bus structures that may further interconnect to a memory bus (with or without a memory controller), a peripheral bus, and/or a local bus using any of a variety of bus architectures. The memory **504** may be one or more devices for storing data and/or computer code for completing or facilitating methods described herein. The memory **504** may include database components, object code components, script components, or other types of information structure for supporting the various activities herein. Any distributed or local memory device may be utilized with the systems and methods of this description. The memory **504** may be communicably connected to the processing circuitry **502** (e.g., via a circuit or any other wired, wireless, or network connection) and may include computer code for executing one or more processes described herein. The memory **504** may include non-volatile memory **508** (e.g., read-only memory (ROM), erasable programmable read-only memory (EPROM), electrically erasable programmable read-only memory (EEPROM), etc.), and volatile memory **510** (e.g., random-access memory (RAM)), or any other medium which can be used to carry or store desired program code in the form of machine-executable instructions or data structures and which can be accessed by a computer or other machine with processing circuitry **502.** A basic input/output system (BIOS) **512** may be stored in the non-volatile memory **508** and can include the basic routines that help to transfer information between elements within the computer system **500.**

The computer system **500** may further include or be coupled to a non-transitory computer-readable storage medium such as the storage device **514,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **514** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **514** and/or in the volatile memory **510,** which may include an operating system **516** and/or one or more program modules **518.** All or a portion of the examples disclosed herein may be implemented as a computer program **520** stored on a transitory or non-transitory computer-usable or computer-readable storage medium (e.g., single medium or multiple media), such as the storage device **514,** which includes complex programming instructions (e.g., complex computer-readable program code) to cause the processing circuitry **502** to carry out actions described herein. Thus, the computer-readable program code of the computer program **520** can comprise software instructions for implementing the functionality of the examples described herein when executed by the processing circuitry **502.** In some examples, the storage device **514** may be a computer program product (e.g., readable storage medium) storing the computer program **520** thereon, where at least a portion of a computer program **520** may be loadable (e.g., into a processor) for implementing the functionality of the examples described herein when executed by the processing circuitry **502.** The processing circuitry **502** may serve as a controller or control system for the computer system **500** that is to implement the functionality described herein.

The computer system **500** may include an input device interface **522** configured to receive input and selections to be communicated to the computer system **500** when executing instructions, such as from a keyboard, mouse, touch-sensitive surface, etc. Such input devices may be connected to the processing circuitry **502** through the input device interface **522** coupled to the system bus **506** but can be connected through other interfaces, such as a parallel port, an Institute of Electrical and Electronic Engineers (IEEE) 1394 serial port, a Universal Serial Bus (USB) port, an IR interface, and the like. The computer system **500** may include an output device interface **524** configured to forward output, such as to a display, a video display unit (e.g., a liquid crystal display (LCD) or a cathode ray tube (CRT)). The computer system **500** may include a communications interface **526** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

**Example 1:** A computer system comprising processing circuitry configured to: perform a flaw check of a first memory section (52) of a first memory node (50) of a data storage module (214, 224); detect a faulty memory block (54) in the first memory section (52) of the first memory node (50); and extend the first memory section (52) of the first memory node (50) with a new memory block (56) corresponding to the faulty memory block (54) of the first memory section (52); wherein the processing circuitry is further configured to: recover the new memory block (56) of the extended first memory section (52) of the first memory node (50) from a backup memory section (58, 58').

**Example 2:** The computer system of Example 1, wherein the processing circuitry is further configured to: perform a flaw check of a backup memory section (58) of the first memory node (50); detect at least one faulty memory block (54) in the backup memory section (58) of the first memory node (50); and recover the new memory block (56) of the extended first memory section (52) of the first memory node (50) from one backup memory section (58') of another memory node (50').

**Example 3:** The computer system of Example 2, wherein the processing circuitry is further configured to: recover the backup memory section (58) of the first memory node (50) from one backup memory section (58') of another memory node (50'); and recover the new memory block (56) of the extended first memory section (52) of the first memory node (50) from the backup memory section (58) of the first memory node (50).

**Example 4:** The computer system of any of Examples 1-3, wherein the processing circuitry is further configured to: extend the first memory section (52) of the first memory node (50) by extending a second non-used memory section (53) of the first memory node with a new memory block (56) corresponding to the faulty memory block (54) of the first memory section (50); and assign the new memory block (56) of the second memory section (53) to the first memory section (52).

**Example 5:** The computer system of any of Examples 1-4, wherein the processing circuitry is further configured to: update the backup memory section (58) of the first memory node (50) from the extended first memory section (52) of the first memory node (50).

**Example 6:** The computer system of any of Example 1-5, wherein the processing circuitry is further configured to: initiate an operational cycle of a battery management system (200); and perform the flaw check of the first memory section (52) of the first memory node (50) when the operational cycle of the battery management system (200) is initiated.

**Example 7:** The computer system of any of Example 1-6, wherein the processing circuitry is further configured to: initiate a data update, and perform the flaw check of the first memory section (52) of the first memory node (50) based on the initiated data update.

**Example 8:** An energy storage system (230), comprising at least one battery pack (232), at least one data storage module (224), and the computer system of any of Examples 1-7.

**Example 9:** A vehicle (1) comprising the energy storage system (230) according to Example 8.

**Example 10:** The vehicle of Example 9, further comprising: a battery management system (200) configured to control the operation of the energy storage system (230), wherein the battery management system (200) comprises at least one data storage module (214, 224).

**Example 11:** The vehicle of Example 9 or 10, wherein the data storage module (214, 224) comprises a plurality of memory nodes (50, 50').

**Example 12:** The vehicle of Example 11, wherein at least one memory node (50) comprises a backup section (58).

**Example 13:** The vehicle of Example 12, wherein the at least one memory node (50) comprises a backup section (58) for each memory node (50, 50') of the data storage module (214, 224).

**Example 14:** The vehicle of Example 12 or 13, wherein each memory node (50, 50') comprises a backup section (58, 58') for each memory node (50, 50') of the data storage module (214, 224).

**Example 15:** A computer-implemented method, comprising: performing, by processing circuitry of a computer system, a flaw check of a first memory section of a first memory node of a data storage module; detecting, by the processing circuitry, a faulty memory block in the first memory section of the first memory node of the data storage module; and extending, by the processing circuitry, the first memory section of the first memory node with a new memory block corresponding to the faulty memory block of the first memory section; wherein the method further comprises: recovering, by the processing circuitry, the new memory block of the extended first memory section of the first memory node from a backup memory section.

**Example 16:** The method of Example 15, wherein the method further comprises: performing, by the processing circuitry, a flaw check of a backup memory section of the first memory node; detecting, by the processing circuitry, at least one faulty memory block in the backup memory section of the first memory node; and recovering, by the processing circuitry, the new memory block of the extended first memory section of the first memory node from one backup memory section of another memory node.

**Example 17:** The method of Example 16, further comprising: recovering, by the processing circuitry, the backup memory section of the first memory node from one backup memory section of another memory node; and recovering, by the processing circuitry, the new memory block of the extended first memory section of the first memory node from the backup memory section of the first memory node.

**Example 18:** The method of any of Examples 15-17, further comprising: extending, by the processing circuitry, the first memory section of the first memory node by extending a second non-used memory section of the first memory node with a new memory block corresponding to the faulty memory block of the first memory section; and assigning, by the processing circuitry, the new memory block of the second memory section to the first memory section.

**Example 19:** The method of any of Examples 15-18, further comprising: updating, by the processing circuitry, the backup memory section of the first memory node from the extended first memory section of the first memory node.

**Example 20:** The method of any of Example 15-19, further comprising: initiating, by the processing circuitry, an operational cycle of a battery management system; and performing, by the processing circuitry, the flaw check of the first memory section of the first memory node when the operational cycle of the battery management system is initiated.

**Example 20:** The method of any of Example 15-20, further comprising: initiating, by the processing circuitry, a data update, and performing, by the processing circuitry, the flaw check of the first memory section of the first memory node based on the initiated data update.

**Example 21:** A computer program product comprising program code for performing, when executed by the processing circuitry, the method of any of Examples 15-20.

**Example 22:** A non-transitory computer-readable storage medium comprising instructions, which when executed by the processing circuitry, cause the processing circuitry to perform the method of any of Examples 15-20.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A computer system comprising processing circuitry configured to:
perform a flaw check of a first memory section (52) of a first memory node (50) of a data storage module (214, 224);
detect a faulty memory block (54) in the first memory section (52) of the first memory node (50); and
extend the first memory section (52) of the first memory node (50) with a new memory block (56) corresponding to the faulty memory block (54) of the first memory section (52);
wherein the processing circuitry is further configured to:
recover the new memory block (56) of the extended first memory section (52) of the first memory node (50) from a backup memory section (58, 58').

2. The computer system of claim 1, wherein the processing circuitry is further configured to:
perform a flaw check of a backup memory section (58) of the first memory node (50);
detect at least one faulty memory block (54) in the backup memory section (58) of the first memory node (50); and
recover the new memory block (56) of the extended first memory section (52) of the first memory node (50) from one backup memory section (58') of another memory node (50').

3. The computer system of claim 2, wherein the processing circuitry is further configured to:
recover the backup memory section (58) of the first memory node (50) from one backup memory section (58') of another memory node (50'); and
recover the new memory block (56) of the extended first memory section (52) of the first memory node (50) from the backup memory section (58) of the first memory node (50).

4. The computer system of any of claims 1-3, wherein the processing circuitry is further configured to:
extend the first memory section (52) of the first memory node (50) by extending a second non-used memory section (53) of the first memory node with a new memory block (56) corresponding to the faulty memory block (54) of the first memory section (50); and
assign the new memory block (56) of the second memory section (53) to the first memory section (52).

5. The computer system of any of claims 1-4, wherein the processing circuitry is further configured to:
update the backup memory section (58) of the first memory node (50) from the extended first memory section (52) of the first memory node (50).

6. The computer system of any of claim 1-5, wherein the processing circuitry is further configured to:
initiate an operational cycle of a battery management system (200); and
perform the flaw check of the first memory section (52) of the first memory node (50) when the operational cycle of the battery management system (200) is initiated.

7. The computer system of any of claim 1-6, wherein the processing circuitry is further configured to:
initiate a data update, and
perform the flaw check of the first memory section (52) of the first memory node (50) based on the initiated data update.

8. An energy storage system (230), comprising at least one battery pack (232), at least one data storage module (224), and the computer system of any of claims 1-7.

9. A vehicle (1) comprising the energy storage system (230) according to claim 8.

10. The vehicle of claim 9, further comprising:
a battery management system (200) configured to control the operation of the energy storage system (230), wherein the battery management system (200) comprises at least one data storage module (214, 224).

11. The vehicle of claim 9 or 10, wherein the data storage module (214, 224) comprises a plurality of memory nodes (50, 50').

12. The vehicle of claim 11, wherein at least one memory node (50) comprises a backup section (58) for each memory node (50, 50') of the data storage module (214, 224).

13. A computer-implemented method, comprising:
performing, by processing circuitry of a computer system, a flaw check of a first memory section of a first memory node of a data storage module;
detecting, by the processing circuitry, a faulty memory block in the first memory section of the first memory node of the data storage module; and
extending, by the processing circuitry, the first memory section of the first memory node with a new memory block corresponding to the faulty memory block of the first memory section;
wherein the method further comprises:
recovering, by the processing circuitry, the new memory block of the extended first memory section of the first memory node from a backup memory section.

14. A computer program product comprising program code for performing, when executed by the processing circuitry, the method of claim 13.

15. A non-transitory computer-readable storage medium comprising instructions, which when executed by the processing circuitry, cause the processing circuitry to perform the method of claim 13.
